# EUROPEAN PATENT APPLICATION

(11) **EP 3 428 800 A1**
(43) Date of publication of application: **16.01.2019**
(21) Application number: 16896613.3
(22) Date of filing: 01.12.2016
(51) Int. Cl.: G06F 11/10

(54) **DATA PROCESSING DEVICE AND DATA PROCESSING METHOD**

(30) Priority: 29.03.2016 CN 201610188091
(71) Applicant: Huawei Technologies Co., Ltd., Longgang District Shenzhen, Guangdong 518129 (CN)
(72) Inventor: ZHANG, Shengbin, Shenzhen Guangdong 518129 (CN); LIN, Qiang, Shenzhen Guangdong 518129 (CN); YANG, Yifeng, Shenzhen Guangdong 518129 (CN)
(74) Representative: Gill Jennings & Every LLP
(86) International application number: PCT/CN2016/108290
(87) International publication number: WO 2017/166845

(57) **Abstract**

Embodiments of this application provide a data processing apparatus and a data processing method. A memory and a CPU of the data processing apparatus are integrated in a package. The data processing apparatus includes data dies, an error checking and correcting ECC die, a double data rate synchronous dynamic random access memory DDR controller, and a DDR physical interface PHY. The data dies and the ECC die are DDR dies of a same data bit width, and the DDR PHY is connected to data interfaces of the data dies and the ECC die. The DDR controller includes a first checking module, a second checking module, and a cache module. Both the first checking module and the second checking module are connected to the cache module, type 1 interfaces of the first checking module and the second checking module are connected to the data interfaces of the data dies by using the DDR PHY, and type 2 interfaces of the first checking module and the second checking module are connected to the data interface of the ECC die by using the DDR PHY. In the embodiments of this application, a checking effect is improved and ECC storage space is fully utilized.

## Description

This application claims priority to Chinese Patent Application No. 201610188091.5, filed with the Chinese Patent Office on March 29, 2016 and entitled "DATA PROCESSING APPARATUS AND DATA PROCESSING METHOD", which is incorporated herein by reference in its entirety.

### TECHNICAL FIELD

Embodiments of this application relate to the computer field, and more specifically, to a data processing apparatus and a data processing method.

### BACKGROUND

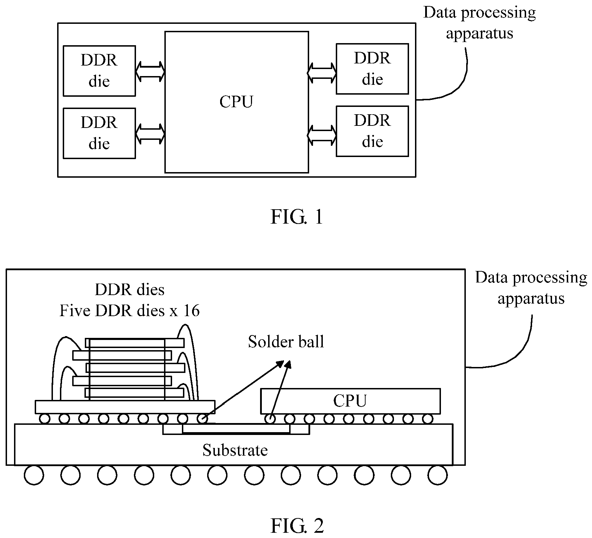

A memory is an important component of a data processing apparatus (the data processing apparatus may be a CPU system). In a prior-art data processing apparatus, a double data rate synchronous dynamic random access memory (Double Data Rate Synchronous Dynamic Random Access Memory, DDR) medium is usually used as a memory for storing code and data required for CPU running. In some scenarios in which a relatively high reliability is required, the data processing apparatus further includes an error checking and correcting (Error Checking and Correcting, ECC) mechanism, so that the entire data processing apparatus operates safely and steadily. In some scenarios in which a quite high requirement is imposed on memory bandwidth but a CPU SoC package has limited pins, a solution in which a memory is packaged together with a CPU is usually used. With reference to FIG. 1 to FIG. 3, the following describes in detail a data processing apparatus used in a memory-on-package scenario.

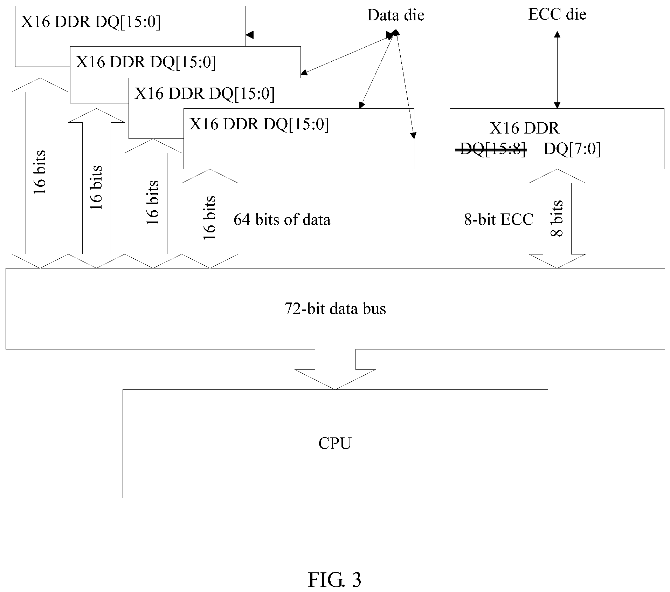

As shown in FIG. 1, a CPU and DDR dies are packaged together to form a data processing apparatus. By packaging the CPU and the DDR dies together, the data processing apparatus can meet a requirement for memory access bandwidth when a CPU SoC package has limited pins. As shown in FIG. 2, because a data processing apparatus obtained by means of combined packaging has relatively limited space, DDR dies are usually arranged by means of 3D stacking. In consideration of heat dissipation or other factors, it is relatively appropriate that the DDR dies should be stacked for less than five layers. Because there should be no excessive layers for stacking, DDR dies of a relatively large data bit width need to be used to reach a specified data bit width. For example, for a data processing apparatus, if a data bit width of 64 bits needs to be reached, five data dies need to be used and the data dies each have a data bit width of 16 bits, as shown in FIG. 3. Four DDR dies are used as data dies to provide a data bit width of 64 bits, and the other DDR die is used as an ECC die to store an ECC code generated during data checking. Generally, 64 bits of data can be checked by using an 8-bit ECC check code. Therefore, only one half of storage space of the ECC die is used to store the ECC check code, and the other half of storage space thereof is in an idle state and is not utilized.

### SUMMARY

This application provides a data processing apparatus, so as to fully utilize storage space of an ECC die inside a data storage apparatus.

According to a first aspect, a data processing apparatus is provided, where a memory and a CPU of the data processing apparatus are integrated in a package, the data processing apparatus includes data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, where k=2ⁿ and n is an integer greater than or equal to 4; and the DDR controller includes a first checking module, a second checking module, and a cache module, where both the first checking module and the second checking module are connected to the cache module, type 1 interfaces of the first checking module and the second checking module are connected to the data interfaces of the data dies by using the DDR PHY, and type 2 interfaces of the first checking module and the second checking module are connected to the data interface of the ECC die by using the DDR PHY; the first checking module is configured to: obtain a first group of data from the cache module, perform ECC checking on the first group of data, generate a k/8-bit ECC check code, store the first group of data in the data dies by using the type 1 interface of the first checking module, and store the k/8-bit ECC check code in the ECC die by using the type 2 interface of the first checking module; and the second checking module is configured to: obtain a second group of data from the cache module, perform ECC checking on the second group of data, generate another k/8-bit ECC check code, store the second group of data in the data dies by using the type 1 interface of the second checking module, and store the another k/8-bit ECC check code in the ECC die by using the type 2 interface of the second checking module, where the first group of data and the second group of data each include k/2 bits of cached data.

For a prior-art data processing apparatus, when a CPU and a memory are packaged together, some storage space of an ECC die is usually in an idle state and is not fully utilized, resulting in a waste of storage space. Each of the two checking modules of the data processing apparatus in this application is connected to the data interfaces of the data dies and the ECC die by using the DDR PHY, so that the cached data can be divided into two groups for ECC checking. In this way, more check codes can be used to check the cached data, and a better checking effect is achieved. In addition, the additionally generated ECC check code is stored in the ECC die, and therefore storage space of the ECC die is fully utilized.

With reference to the first aspect, in a first implementation of the first aspect, n=6, the data dies are four DDR dies that each have a data bit width of 16 bits, and the ECC die is one DDR die that has a data bit width of 16 bits; the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY; the first checking module is configured to: obtain 32 bits of data from the cache module, perform ECC checking on the 32 bits of data, generate an 8-bit ECC check code, store the 32 bits of data in the first data die and the second data die by using the type 1 interface of the first checking module, and store the 8-bit ECC check code in the ECC die by using the type 2 interface of the first checking module; and the second checking module is configured to: obtain another 32 bits of data from the cache module, perform ECC checking on the another 32 bits of data, generate another 8-bit ECC check code, store the another 32 bits of data in the third data die and the fourth data die by using the type 1 interface of the second checking module, and store the another 8-bit ECC check code in the ECC die by using the type 2 interface of the second checking module. With reference to the first aspect, in a second implementation of the first aspect, n=5, the data dies are two DDR dies that each have a data bit width of 16 bits, and the ECC die is one DDR die that has a data bit width of 16 bits; the type 1 interface of the first checking module is connected to a data interface of a first data die among the data dies by using the DDR PHY, and the type 1 interface of the second checking module is connected to a data interface of a second data die among the data dies by using the DDR PHY; the first checking module is configured to: obtain 16 bits of data from the cache module, perform ECC checking on the 16 bits of data, generate an 8-bit ECC check code, store the 16 bits of data in the first data die by using the type 1 interface of the first checking module, and store the 8-bit ECC check code in the ECC die by using the type 2 interface of the first checking module; and the second checking module is configured to: obtain another 16 bits of data from the cache module, perform ECC checking on the another 16 bits of data, generate another 8-bit ECC check code, store the 16 bits of data in the second data die by using the type 1 interface of the second checking module, and store the another 8-bit ECC check code in the ECC die by using the type 2 interface of the second checking module.

Compared with a prior-art data processing apparatus, the data processing apparatus in this application generates another 8-bit ECC check code, so that a better checking effect is achieved during data storage. Compared with a case in which the prior-art data processing apparatus can correct an error of 1 bit and detect an error of more than 2 bits for each unit of 64 bits, the data processing apparatus in this application can correct an error of 2 bits and detect an error of more than 4 bits for each unit of 64 bits. In addition, the additional 8-bit ECC check code is stored in the ECC die, and therefore storage space of the ECC die is fully utilized.

With reference to the first aspect, in a second implementation of the first aspect, n=5, the data dies are two DDR dies that each have a data bit width of 16 bits, and the ECC die is one DDR die that has a data bit width of 16 bits; the type 1 interface of the first checking module is connected to a data interface of a first data die among the data dies by using the DDR PHY, and the type 1 interface of the second checking module is connected to a data interface of a second data die among the data dies by using the DDR PHY; the first checking module is configured to: obtain 16 bits of data from the cache module, perform ECC checking on the 16 bits of data, generate an 8-bit ECC check code, store the 16 bits of data in the first data die by using the type 1 interface of the first checking module, and store the 8-bit ECC check code in the ECC die by using the type 2 interface of the first checking module; and the second checking module is configured to: obtain another 16 bits of data from the cache module, perform ECC checking on the another 16 bits of data, generate another 8-bit ECC check code, store the 16 bits of data in the second data die by using the type 1 interface of the second checking module, and store the another 8-bit ECC check code in the ECC die by using the type 2 interface of the second checking module.

With reference to the first aspect, in a third implementation of the first aspect, n=5, the data dies are four DDR dies that each have a data bit width of 8 bits, and the ECC die is one DDR die that has a data bit width of 8 bits; the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY; the first checking module is configured to: obtain 16 bits of data from the cache module, perform ECC checking on the 16 bits of data, generate a 4-bit ECC check code, store the 16 bits of data in the first data die and the second data die by using the type 1 interface of the first checking module, and store the 4-bit ECC check code in the ECC die by using the type 2 interface of the first checking module; and the second checking module is configured to: obtain another 16 bits of data from the cache module, perform ECC checking on the another 16 bits of data, generate another 4-bit ECC check code, store the 16 bits of data in the third data die and the fourth data die by using the type 1 interface of the second checking module, and store the another 4-bit ECC check code in the ECC die by using the type 2 interface of the second checking module.

According to a second aspect, a data processing apparatus is provided, where a memory and a CPU of the data processing apparatus are integrated in a package, the data processing apparatus includes data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, where k=2ⁿ, n is an integer greater than or equal to 4, and the data dies are configured to store data required for CPU running; and the DDR controller includes a checking module and a cache module, where the checking module is connected to the data interfaces of the data dies and the ECC die by using the DDR PHY, and the checking module is further connected to the cache module; and the checking module is configured to: obtain k+m bits of cached data from the cache module, perform ECC checking on the k+m bits of cached data, generate a (1+k/8)-bit ECC check code, store the k bits of cached data in the data dies, and store the (1+k/8)-bit ECC check code and the m bits of cached data in the ECC die, where 0<m<k/8 and m is an integer.

For a prior-art data processing apparatus, when a CPU and a memory are packaged together, some storage space of an ECC die is usually in an idle state and is not fully utilized, resulting in a waste of storage space. In the data processing apparatus in this application, the checking module is connected to all the data interfaces of the data dies and the ECC die by using the DDR PHY. The checking module can obtain the k+m bits of cached data from the cache module, generate the (1+k/8)-bit ECC check code, and store the (1+k/8)-bit ECC check code and the m bits of cached data in the ECC die. Compared with the prior-art data processing apparatus whose ECC die stores only a k/8-bit ECC check code, the ECC die of the data processing apparatus in this application can store more cached data and check codes, and therefore storage space of the ECC die is fully utilized.

With reference to the second aspect, in a first implementation of the second aspect, n=6, the data dies are four DDR dies that each have a data bit width of 16 bits, and the ECC die is one DDR die that has a data bit width of 16 bits; and the checking module is configured to: obtain 64+m bits of cached data from the cache module, perform ECC checking on the 64+m bits of cached data, generate a 9-bit ECC check code, store the 64 bits of cached data in the data dies, and store the 9-bit ECC check code and the m bits of cached data in the ECC die, where 0<m<8 and m is an integer.

With reference to the second aspect, in a second implementation of the second aspect, n=5, the data dies are two DDR dies that each have a data bit width of 16 bits, and the ECC die is one DDR die that has a data bit width of 16 bits; and the checking module is configured to: obtain 32+m bits of cached data from the cache module, perform ECC checking on the 32+m bits of cached data, generate a 9-bit ECC check code, store the 32 bits of cached data in the data dies, and store the 9-bit ECC check code and the m bits of cached data in the ECC die, where 0<m<8 and m is an integer.

With reference to any one of the second aspect, or the first and the second implementations of the second aspect, in a third implementation of the second aspect, the m bits of cached data are TAG information and/or directory information cached by the CPU.

According to a third aspect, a data processing method is provided, where the method is applied to a data processing apparatus, the method is applied to the data processing apparatus, a memory and a CPU of the data processing apparatus are integrated in a package, the data processing apparatus includes data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, where k=2ⁿ and n is an integer greater than or equal to 4; and the DDR controller includes a first checking module, a second checking module, and a cache module, where both the first checking module and the second checking module are connected to the cache module, type 1 interfaces of the first checking module and the second checking module are connected to the data interfaces of the data dies by using the DDR PHY, and type 2 interfaces of the first checking module and the second checking module are connected to the data interface of the ECC die by using the DDR PHY; the first checking module obtains a first group of data from the cache module, performs ECC checking on the first group of data, generates a k/8-bit ECC check code, stores the first group of data in the data dies by using the type 1 interface of the first checking module, and stores the k/8-bit ECC check code in the ECC die by using the type 2 interface of the first checking module; and the second checking module obtains a second group of data from the cache module, performs ECC checking on the second group of data, generates another k/8-bit ECC check code, stores the second group of data in the data dies by using the type 1 interface of the second checking module, and stores the another k/8-bit ECC check code in the ECC die by using the type 2 interface of the second checking module, where the first group of data and the second group of data each contain k/2 bits of cached data.

When a prior-art data processing apparatus is processing data, because not all data interfaces for storage space of an ECC die are connected to a DDR controller, during data operation or processing, some storage space of the ECC die is usually in an idle state and is not fully utilized, resulting in a waste of storage space. Each of the two checking modules of the data processing apparatus to which the data processing method in this application is applied is connected to all the data interfaces of the data dies and the ECC die by using the DDR PHY, so that the cached data can be divided into two groups for ECC checking. In this way, more check codes can be used to check the cached data, and a better checking effect is achieved. In addition, the additionally generated ECC check code is stored in the ECC die, and therefore storage space of the ECC die is fully utilized.

With reference to the third aspect, in a first implementation of the third aspect, n=6, the data dies are four DDR dies that each have a data bit width of 16 bits, and the ECC die is one DDR die that has a data bit width of 16 bits; the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY; the first checking module obtains 32 bits of data from the cache module, performs ECC checking on the 32 bits of data, generates an 8-bit ECC check code, stores the 32 bits of data in the first data die and the second data die by using the type 1 interface of the first checking module, and stores the 8-bit ECC check code in the ECC die by using the type 2 interface of the first checking module; and the second checking module obtains another 32 bits of data from the cache module, performs ECC checking on the another 32 bits of data, generates another 8-bit ECC check code, stores the another 32 bits of data in the third data die and the fourth data die by using the type 1 interface of the second checking module, and stores the another 8-bit ECC check code in the ECC die by using the type 2 interface of the second checking module.

Compared with data processing by a prior-art data processing apparatus, in the data processing method in this application, ECC check codes of 16 bits are generated, so that a better checking effect is achieved during data storage. Compared with a case in which the prior-art data processing apparatus can correct an error of 1 bit and detect an error of more than 2 bits for each unit of 64 bits, the data processing apparatus in the data processing method in this application can correct an error of 2 bits and detect an error of more than 4 bits for each unit of 64 bits. In addition, the additional 8-bit ECC check code is stored in the ECC die, and therefore storage space of the ECC die is fully utilized.

With reference to the third aspect, in a second implementation of the third aspect, n=5, the data dies are two DDR dies that each have a data bit width of 16 bits, and the ECC die is one DDR die that has a data bit width of 16 bits; the type 1 interface of the first checking module is connected to a data interface of a first data die among the data dies by using the DDR PHY, and the type 1 interface of the second checking module is connected to a data interface of a second data die among the data dies by using the DDR PHY; the first checking module obtains 16 bits of data from the cache module, performs ECC checking on the 16 bits of data, generates an 8-bit ECC check code, stores the 16 bits of data in the first data die by using the type 1 interface of the first checking module, and stores the 8-bit ECC check code in the ECC die by using the type 2 interface of the first checking module; and the second checking module obtains another 16 bits of data from the cache module, performs ECC checking on the another 16 bits of data, generates another 8-bit ECC check code, stores the 16 bits of data in the second data die by using the type 1 interface of the second checking module, and stores the another 8-bit ECC check code in the ECC die by using the type 2 interface of the second checking module.

With reference to the third aspect, in a third implementation of the third aspect, n=5, the data dies are four DDR dies that each have a data bit width of 8 bits, and the ECC die is one DDR die that has a data bit width of 8 bits; the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY; the first checking module obtains 16 bits of data from the cache module, performs ECC checking on the 16 bits of data to generates a 4-bit ECC check code, stores the 16 bits of data in the first data die and the second data die by using the type 1 interface of the first checking module, and stores the 4-bit ECC check code in the ECC die by using the type 2 interface of the first checking module; and the second checking module obtains another 16 bits of data from the cache module, performs ECC checking on the another 16 bits of data to generate another 4-bit ECC check code, stores the 16 bits of data in the third data die and the fourth data die by using the type 1 interface of the second checking module, and stores the another 4-bit ECC check code in the ECC die by using the type 2 interface of the second checking module.

According to a fourth aspect, a data processing method is provided, where the method is applied to a data processing apparatus, a memory and a CPU of the data processing apparatus are integrated in a package, the data processing apparatus includes data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, where k=2ⁿ and n is an integer greater than or equal to 4; and the DDR controller includes a checking module and a cache module, where the checking module is connected to the data interfaces of the data dies and the ECC die by using the DDR PHY, and the checking module is further connected to the cache module; and the checking module obtains k+m bits of cached data from the cache module, performs ECC checking on the k+m bits of cached data, generates a (1+k/8)-bit ECC check code, stores the k bits of cached data in the data dies, and stores the (1+k/8)-bit ECC check code and the m bits of cached data in the ECC die, where 0<m<k/8 and m is an integer.

For a prior-art data processing apparatus, when a CPU and a memory are packaged together, some storage space of an ECC die is usually in an idle state and is not fully utilized, resulting in a waste of storage space. In the data processing apparatus to which the data processing method in this application is applied, the checking module is connected to all the data interfaces of the data dies and the ECC die by using the DDR PHY. In this way, during data processing, the checking module can be used to obtain the k+m bits of cached data from the cache module, generate the (1+k/8)-bit ECC check code, and store the (1+k/8)-bit ECC check code and the m bits of cached data in the ECC die. Compared with a prior-art data processing method in which an ECC die stores only a k/8-bit ECC check code, in the data processing method in this application, more cached data and check codes can be stored in the ECC die, and therefore storage space of the ECC die is fully utilized.

With reference to the fourth aspect, in a first implementation of the fourth aspect, n=6, the data dies are four DDR dies that each have a data bit width of 16 bits, and the ECC die is one DDR die that has a data bit width of 16 bits; and the checking module obtains 64+m bits of cached data from the cache module, performs ECC checking on the 64+m bits of cached data, generates a 9-bit ECC check code, stores the 64 bits of cached data in the data dies, and stores the 9-bit ECC check code and the m bits of cached data in the ECC die, where 0<m<8 and m is an integer.

With reference to the fourth aspect, in a second implementation of the fourth aspect, n=5, the data dies are two DDR dies that each have a data bit width of 16 bits, and the ECC die is one DDR die that has a data bit width of 16 bits; and the checking module obtains 32+m bits of cached data from the cache module, performs ECC checking on the 32+m bits of cached data, generates a 9-bit ECC check code, stores the 32 bits of cached data in the data dies, and stores the 9-bit ECC check code and the m bits of cached data in the ECC die, where 0<m<8 and m is an integer.

With reference to any one of the fourth aspect, or the first and the second implementations of the fourth aspect, in a third implementation of the fourth aspect, the m bits of cached data are TAG information and/or directory information cached by the CPU.

In some implementations, a bit width of data interfaces of the DDR controller of the data processing apparatus is 160 bits, and a total data bit width of the data dies and the ECC die is 80 bits.

In some implementations, the data dies are configured to store data required for CPU running, and the ECC die is configured to store an ECC check code generated by ECC checking on the data stored by the data dies.

In some implementations, the data processing apparatus is a CPU system.

In some implementations, the memory and the CPU of the data processing apparatus are integrated on a chip.

In some implementations, the memory and the CPU of the data processing apparatus are packaged together.

In some implementations, the CPU includes a CPU core, a memory controller, and an Ethernet controller.

In this application, each of the two checking modules of the DDR controller of the data processing apparatus is connected to the data interfaces of the data dies and the ECC die by using the DDR PHY, so that the cached data can be divided into two groups for ECC checking. In this way, more check codes can be used to check the cached data, and a better checking effect is achieved. In addition, the additionally generated ECC check code is stored in the ECC die, and therefore storage space of the ECC die is fully utilized.

### BRIEF DESCRIPTION OF DRAWINGS

FIG. 1 is a schematic block diagram of a prior-art data processing apparatus;
FIG. 2 is a schematic block diagram of a prior-art data processing apparatus;
FIG. 3 is a schematic block diagram of a prior-art data processing apparatus;
FIG. 4 is a schematic block diagram of a data processing apparatus according to an embodiment of this application;
FIG. 5 is a schematic block diagram of a data processing apparatus according to an embodiment of this application;
FIG. 6 is a schematic block diagram of a data processing apparatus according to an embodiment of this application; and
FIG. 7 is a schematic block diagram of a data processing apparatus according to an embodiment of this application.

### DESCRIPTION OF EMBODIMENTS

The following describes the technical solutions in the embodiments of this application with reference to the accompanying drawings in the embodiments of this application.

In a data processing apparatus shown in FIG. 3, a memory and a CPU of the data processing apparatus are integrated in a package. A half of storage space of an ECC die of the data processing apparatus is in an idle state and is not utilized, resulting in a waste of ECC storage space. To utilize the remaining storage space of the ECC die, all data interfaces of the ECC die may be connected to a DDR controller by using a DDR PHY, and the DDR controller is improved based on the prior-art data processing apparatus, so that the DDR controller can use more ECC codes to implement more accurate checking on stored data and store an additional ECC code in the remaining storage space of the ECC die. Alternatively, one part of the remaining storage space of the ECC die may be used to store an additional ECC code and the other part thereof is used to store some cached information, or all the remaining storage space of the ECC die is used to store cached information. With reference to specific embodiments, the following describes in detail a data processing apparatus according to an embodiment of this application.

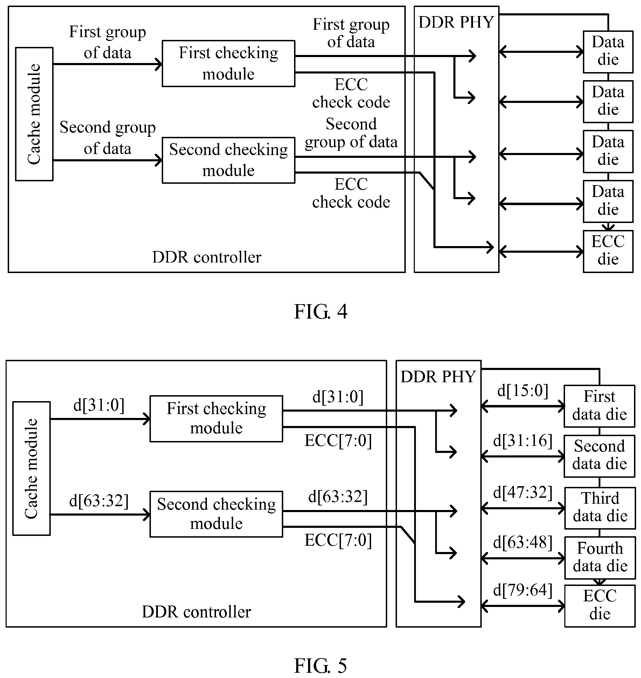

FIG. 4 shows a data processing apparatus according to an embodiment of this application. As shown in FIG. 4, the data processing apparatus includes a DDR controller, a DDR PHY (the DDR PHY is a physical interface that connects a CPU to DDR dies and an ECC die), data dies, and the ECC die. The DDR controller includes a cache module, a first checking module, and a second checking module. The data dies and the ECC die are DDR dies of a same specification. A total data bit width of the data dies is k bits, where k=2ⁿ and n is an integer greater than or equal to 4. Both one end of the first checking module and one end of the second checking module are connected to the cache module of the DDR controller, and the other end of the first checking module and the other end of the second checking module both include two types of interfaces, which are a type 1 interface and a type 2 interface. The type 1 interfaces are connected to data interfaces of the data dies by using the DDR PHY, and the type 2 interfaces are connected to a data interface of the ECC die by using the DDR PHY. It should be understood that the data dies herein can be configured to store data required during CPU running, and the ECC die can be configured to store an ECC check code generated by ECC checking on data required during CPU running.

The cache module can cache the data to be stored in the data dies. For example, the cache module can cache k bits of data. The first checking module can obtain a first group of data from the cache module, perform ECC checking on the first group of data, generate a k/8-bit ECC check code, store the first group of data in the data dies by using the type 1 interface of the first checking module, and store the k/8-bit ECC check code in the ECC die by using the type 2 interface of the first checking module.

Likewise, the second checking module can obtain a second group of data from the cache module, perform ECC checking on the second group of data, generate another k/8-bit ECC check code, store the second group of data in the data dies by using the type 1 interface of the second checking module, and store the another k/8-bit ECC check code in the ECC die by using the type 2 interface of the second checking module. The first group of data and the second group of data each include k/2 bits of cached data.

In this application, each of the two checking modules of the DDR controller is connected to the data interfaces of the data dies and the ECC die by using the DDR PHY, so that the cached data can be divided into two groups for ECC checking. In this way, more check codes can be used to check the cached data, and a better checking effect is achieved. In addition, the additionally generated ECC check code is stored in the ECC die, and therefore storage space of the ECC die is fully utilized.

Optionally, in an embodiment, when n=6, data dies and a DDR die are DDR dies that each have a data bit width of 16 bits, in a data processing apparatus, the data dies are four DDR dies that each have a data bit width of 16 bits, and an ECC die is one DDR die that has a data bit width of 16 bits. In this case, the data processing apparatus according to this embodiment of this application may be a data processing apparatus shown in FIG. 5. As shown in FIG. 5, a type 1 interface of a first checking module is connected to data interfaces of a first data die and a second data die among the data dies by using a DDR PHY, and a type 1 interface of the second checking module is connected to data interfaces of a third data die and a fourth data die among the data dies by using the DDR PHY. A DDR controller herein includes two checking modules. Generally, a prior-art data processing apparatus includes only one checking module. In the prior-art data processing apparatus, the checking module obtains 64 bits of data from a cache module, generates an 8-bit ECC check code during a process of checking the 64 bits of data, separately stores the 64 bits of data in four data dies, and stores the 8-bit ECC check code in an ECC die. In this case, only one half of storage space of the ECC die is used to store the 8-bit ECC check code, and the other half of storage space is in an idle state. Therefore, the storage space is not fully utilized. A DDR controller of the data processing apparatus in this embodiment of this application has two checking modules. During ECC checking on 64 bits of data, the 64 bits of data can be divided into two groups, and each group has 32 bits of data; the two checking modules (that is, the first checking module and the second checking module) perform checking on two groups of 32 bits of data, respectively. During checking, to improve checking accuracy, the first checking module and the second checking module each generate an 8-bit ECC check code when checking respective 32 bits of data. After checking is completed, the 64 bits of data are still stored in the four data dies, and ECC check codes of 16 bits in total are stored in the ECC die. Compared with the prior-art data processing apparatus, a quantity of ECC check codes generated in the data processing apparatus in this embodiment of this application is twice of that generated in the prior-art data processing apparatus. For the prior-art data processing apparatus, the 8-bit ECC check code can be used to correct an error of 1 bit and detect an error of more than 2 bits in the 64 bits of data, whereas in this embodiment of this application, because ECC check codes are increased to 16 bits, the ECC check codes of 16 bits in total can be used to correct an error of 2 bits and detect an error of more than 4 bits in the 64 bits of data. Therefore, the data processing apparatus in this embodiment of this application not only improves checking accuracy, but also fully utilizes surplus storage space of the ECC die.

Optionally, in an embodiment, when n=5, a total data bit width of a data processing apparatus is 32 bits, and data dies and a DDR die of the data processing apparatus are DDR dies that each have a data bit width of 16 bits. The data dies are two DDR dies that each have a data bit width of 16 bits, and an ECC die is one DDR die that has a data bit width of 16 bits. Similar to the data processing apparatus shown in FIG. 5, the data processing apparatus also includes two checking modules, namely, a first checking module and a second checking module. A type 1 interface of the first checking module is connected to a data interface of a first data die among the data dies by using a DDR PHY, and a type 1 interface of the second checking module is connected to a data interface of a second data die among the data dies by using the DDR PHY. Different from the data processing apparatus in FIG. 5, the data processing apparatus stores 32 bits of data in the data dies every time. During a data storage process, the 32 bits of data are divided into two groups, and each group includes 16 bits of data. The two groups of 16 bits of data are checked by the first checking module and the second checking module, respectively. The first checking module and the second checking module each generate an 8-bit ECC check code when checking respective 16 bits of data. After checking is completed, the 32 bits of data are still stored in the two data dies, and the ECC check codes of 16 bits in total are stored in the ECC die. This not only improves checking accuracy, but also fully utilizes surplus storage space of the ECC die.

Optionally, in an embodiment, when n=5, that is, a total data bit width of a data processing apparatus is 32 bits, data dies and a DDR die of the data processing apparatus are DDR dies that each have a data bit width of 8 bits. The data dies are four DDR dies that each have a data bit width of 8 bits, and an ECC die is one DDR die that has a data bit width of 8 bits. Similar to the data processing apparatus shown in FIG. 5, the data processing apparatus also includes two checking modules, namely, a first checking module and a second checking module. A type 1 interface of the first checking module is connected to data interfaces of a first data die and a second data die among the data dies by using a DDR PHY, and a type 1 interface of the second checking module is connected to data interfaces of a third data die and a fourth data die among the data dies by using the DDR PHY. Different from the data processing apparatus in FIG. 5, the data processing apparatus stores 32 bits of data in the data dies every time. During a data storage process, the 32 bits of data are divided into two groups, and each group includes 16 bits of data. The two groups of 16 bits of data are checked by the first checking module and the second checking module, respectively. The first checking module and the second checking module each generate a 4-bit ECC check code when checking respective 16 bits of data. After checking is completed, the 32 bits of data are still stored in the four data dies, and the ECC check codes of 8 bits in total are stored in the ECC die. This not only improves checking accuracy, but also fully utilizes surplus storage space of the ECC die.

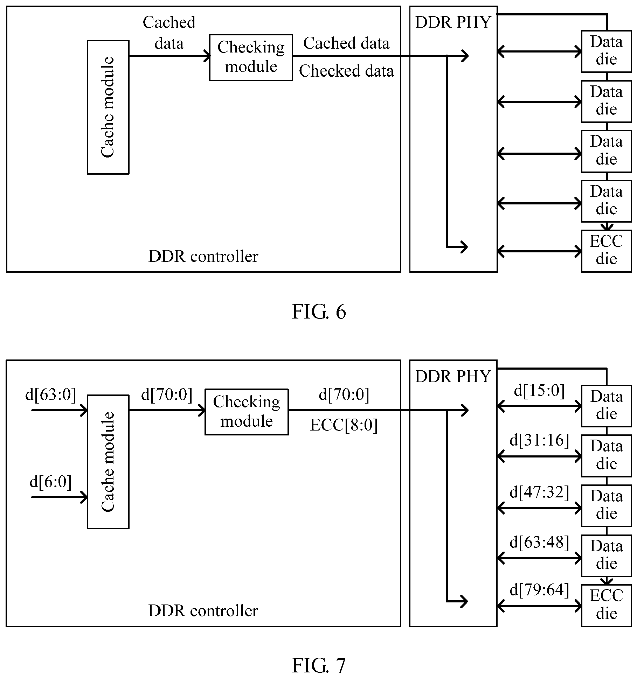

FIG. 6 shows a data processing apparatus according to an embodiment of this application. As shown in FIG. 6, the data processing apparatus includes data dies, an ECC die, and a DDR controller, where the data dies and the ECC die are DDR dies of a same specification. The data dies are configured to store data required during CPU running, and the ECC die is configured to store an ECC check code generated by ECC checking on the data required during CPU running. A total data bit width of the data dies is k bits, where k=2ⁿ and n is an integer greater than or equal to 4. The DDR controller includes a checking module and a cache module. The checking module is connected to data interfaces of the data dies and the ECC die, and the checking module is further connected to the cache module. Different from the data processing apparatuses shown in FIG. 4 and FIG. 5, the DDR controller of the data processing apparatus includes only one checking module. Grouping is not performed when the checking module performs ECC checking on the data in the cache module. In this case, to fully utilize storage space of the ECC die, storage space remaining after an ECC check code is stored may be used to store some data and/or another ECC check code. In this way, the storage space of the ECC die is fully utilized.

In this application, the checking module is connected to all the data interfaces of the data dies and the ECC die, so that some cached data or a newly-added ECC check code can be stored in surplus storage space of the ECC die. Therefore, the storage space of the ECC die is fully utilized.

Optionally, in an embodiment, FIG. 7 shows a data processing apparatus. In the data processing apparatus, n=6 and data dies and a DDR die are DDR dies of 16 bits. For example, when a checking module obtains 64+m bits of cached data from a cache module, the checking module may perform ECC checking on the 64+m bits of cached data, generate a 9-bit ECC check code, store the 64 bits of cached data in the data dies, and store the 9-bit ECC check code and the m bits of cached data in the ECC die, where 0<m<8 and m is an integer. Optionally, when a checking module obtains 64+m bits of cached data from a cache module, the checking module may generate only an 8-bit ECC check code during ECC checking on the cached data (although a checking effect may be relatively poor in this case), store the 64 bits of cached data in the data dies, and store the 8-bit ECC check code and the m bits of cached data in the ECC die, where 0<m≤8. That is, in this case, all remaining space of the ECC die can be used to store cached data.

More specifically, when the checking module obtains 71 bits of cached data from the cache module, the checking module may perform ECC checking on the 71 bits of cached data, generate a 9-bit ECC check code, store 64 bits of cached data in the data dies, and store the 9-bit ECC check code and remaining 7 bits of cached data in the ECC die. In this case, not only the newly generated ECC check code but also some other cached data can be stored in the remaining storage space of the ECC die. Therefore, the storage space is effectively used to store some cached data, and a checking effect is improved. In addition, the m bits of cached data are TAG information and/or directory information cached by a CPU. That is, the remaining storage space of the ECC die can be used to store the TAG information and/or directory information.

Optionally, in an embodiment, when n=5, a total data bit width of a data processing apparatus is 32 bits, and data dies and a DDR die of the data processing apparatus are DDR dies that each have a data bit width of 16 bits. The data dies are two DDR dies that each have a data bit width of 16 bits, and an ECC die is one DDR die that has a data bit width of 16 bits. When a checking module obtains 32+m bits of cached data from a cache module, the checking module may perform ECC checking on the 32+m bits of cached data, generate a 9-bit ECC check code, store 32 bits of cached data in the data dies, and store the 9-bit ECC check code and the m bits of cached data in the ECC die, where 0<m<8 and m is an integer.

The foregoing describes in detail the data processing apparatuses in the embodiments of this application with reference to FIG. 4 to FIG. 7. It should be understood that the data processing methods in the embodiments of this application can be used for data processing by using the data processing apparatuses in FIG. 4 to FIG. 7. For brevity, details are not described herein again.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of the embodiments.

In addition, functional units in the embodiments of the present application may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The software product is stored in a storage medium, and includes several instructions for instructing a computer device (which may be a personal computer, a server, or a network device) to perform all or some of the steps of the methods described in the embodiments of this application. The foregoing storage medium includes: any medium that can store program verification code, such as a USB flash drive, a removable hard disk, a read-only memory (ROM, Read-Only Memory), a random access memory (RAM, Random Access Memory), a magnetic disk, or an optical disc.

The foregoing descriptions are merely specific implementation manners of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A data processing apparatus, wherein a memory and a CPU of the data processing apparatus are integrated in a package, the data processing apparatus comprises data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, wherein k=2ⁿ, and n is an integer greater than or equal to 4; and
the DDR controller comprises a first checking module, a second checking module, and a cache module, wherein both the first checking module and the second checking module are connected to the cache module, type 1 interfaces of the first checking module and the second checking module are connected to the data interfaces of the data dies by using the DDR PHY, and type 2 interfaces of the first checking module and the second checking module are connected to the data interface of the ECC die by using the DDR PHY;
the first checking module is configured to: obtain a first group of data from the cache module, perform ECC checking on the first group of data, generate a k/8-bit ECC check code, store the first group of data in the data dies by using the type 1 interface of the first checking module, and store the k/8-bit ECC check code in the ECC die by using the type 2 interface of the first checking module; and
the second checking module is configured to: obtain a second group of data from the cache module, perform ECC checking on the second group of data, generate another k/8-bit ECC check code, store the second group of data in the data dies by using the type 1 interface of the second checking module, and store the another k/8-bit ECC check code in the ECC die by using the type 2 interface of the second checking module, wherein the first group of data and the second group of data each comprise k/2 bits of cached data.

2. The data processing apparatus according to claim 1, wherein n=6, the data dies are four DDR dies that each have a data bit width of 16 bits, and the ECC die is one DDR die that has a data bit width of 16 bits;
the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY;
the first checking module is configured to: obtain 32 bits of data from the cache module, perform ECC checking on the 32 bits of data, generate an 8-bit ECC check code, store the 32 bits of data in the first data die and the second data die by using the type 1 interface of the first checking module, and store the 8-bit ECC check code in the ECC die by using the type 2 interface of the first checking module; and
the second checking module is configured to: obtain another 32 bits of data from the cache module, perform ECC checking on the another 32 bits of data, generate another 8-bit ECC check code, store the another 32 bits of data in the third data die and the fourth data die by using the type 1 interface of the second checking module, and store the another 8-bit ECC check code in the ECC die by using the type 2 interface of the second checking module.

3. The data processing apparatus according to claim 1, wherein n=5, the data dies are two DDR dies that each have a data bit width of 16 bits, and the ECC die is one DDR die that has a data bit width of 16 bits;
the type 1 interface of the first checking module is connected to a data interface of a first data die among the data dies by using the DDR PHY, and the type 1 interface of the second checking module is connected to a data interface of a second data die among the data dies by using the DDR PHY;
the first checking module is configured to: obtain 16 bits of data from the cache module, perform ECC checking on the 16 bits of data, generate an 8-bit ECC check code, store the 16 bits of data in the first data die by using the type 1 interface of the first checking module, and store the 8-bit ECC check code in the ECC die by using the type 2 interface of the first checking module; and
the second checking module is configured to: obtain another 16 bits of data from the cache module, perform ECC checking on the another 16 bits of data, generate another 8-bit ECC check code, store the 16 bits of data in the second data die by using the type 1 interface of the second checking module, and store the another 8-bit ECC check code in the ECC die by using the type 2 interface of the second checking module.

4. The data processing apparatus according to claim 1, wherein n=5, the data dies are four DDR dies that each have a data bit width of 8 bits, and the ECC die is one DDR die that has a data bit width of 8 bits;
the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY;
the first checking module is configured to: obtain 16 bits of data from the cache module, perform ECC checking on the 16 bits of data, generate a 4-bit ECC check code, store the 16 bits of data in the first data die and the second data die by using the type 1 interface of the first checking module, and store the 4-bit ECC check code in the ECC die by using the type 2 interface of the first checking module; and
the second checking module is configured to: obtain another 16 bits of data from the cache module, perform ECC checking on the another 16 bits of data, generate another 4-bit ECC check code, store the 16 bits of data in the third data die and the fourth data die by using the type 1 interface of the second checking module, and store the another 4-bit ECC check code in the ECC die by using the type 2 interface of the second checking module.

5. A data processing apparatus, wherein a memory and a CPU of the data processing apparatus are integrated in a package, the data processing apparatus comprises data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, wherein k=2ⁿ, n is an integer greater than or equal to 4, and the data dies are configured to store data required for CPU running; and
the DDR controller comprises a checking module and a cache module, wherein the checking module is connected to the data interfaces of the data dies and the ECC die by using the DDR PHY, and the checking module is further connected to the cache module; and
the checking module is configured to: obtain k+m bits of cached data from the cache module, perform ECC checking on the k+m bits of cached data, generate a (1+k/8)-bit ECC check code, store the k bits of cached data in the data dies, and store the (1+k/8)-bit ECC check code and the m bits of cached data in the ECC die, wherein 0<m<k/8 and m is an integer.

6. The data processing apparatus according to claim 5, wherein n=6, the data dies are four DDR dies that each have a data bit width of 16 bits, and the ECC die is one DDR die that has a data bit width of 16 bits; and
the checking module is configured to: obtain 64+m bits of cached data from the cache module, perform ECC checking on the 64+m bits of cached data, generate a 9-bit ECC check code, store the 64 bits of cached data in the data dies, and store the 9-bit ECC check code and the m bits of cached data in the ECC die, wherein 0<m<8 and m is an integer.

7. The data processing apparatus according to claim 5, wherein n=5, the data dies are two DDR dies that each have a data bit width of 16 bits, and the ECC die is one DDR die that has a data bit width of 16 bits; and
the checking module is configured to: obtain 32+m bits of cached data from the cache module, perform ECC checking on the 32+m bits of cached data, generate a 9-bit ECC check code, store the 32 bits of cached data in the data dies, and store the 9-bit ECC check code and the m bits of cached data in the ECC die, wherein 0<m<8 and m is an integer.

8. The data processing apparatus according to any one of claims 5 to 7, wherein the m bits of cached data are TAG information and/or directory information cached by the CPU.

9. A data processing method, wherein the method is applied to a data processing apparatus, a memory and a CPU of the data processing apparatus are integrated in a package, the data processing apparatus comprises data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, wherein k=2ⁿ and n is an integer greater than or equal to 4; and the DDR controller comprises a first checking module, a second checking module, and a cache module, wherein both the first checking module and the second checking module are connected to the cache module, type 1 interfaces of the first checking module and the second checking module are connected to the data interfaces of the data dies by using the DDR PHY, and type 2 interfaces of the first checking module and the second checking module are connected to the data interface of the ECC die by using the DDR PHY;
the first checking module obtains a first group of data from the cache module, performs ECC checking on the first group of data, generates a k/8-bit ECC check code, stores the first group of data in the data dies by using the type 1 interface of the first checking module, and stores the k/8-bit ECC check code in the ECC die by using the type 2 interface of the first checking module; and
the second checking module obtains a second group of data from the cache module, performs ECC checking on the second group of data, generates another k/8-bit ECC check code, stores the second group of data in the data dies by using the type 1 interface of the second checking module, and stores the another k/8-bit ECC check code in the ECC die by using the type 2 interface of the second checking module, wherein the first group of data and the second group of data each comprise k/2 bits of cached data.

10. The method according to claim 9, wherein n=6, the data dies are four DDR dies that each have a data bit width of 16 bits, and the ECC die is one DDR die that has a data bit width of 16 bits; the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY;
the first checking module obtains 32 bits of data from the cache module, performs ECC checking on the 32 bits of data, generates an 8-bit ECC check code, stores the 32 bits of data in the first data die and the second data die by using the type 1 interface of the first checking module, and stores the 8-bit ECC check code in the ECC die by using the type 2 interface of the first checking module; and
the second checking module obtains another 32 bits of data from the cache module, performs ECC checking on the another 32 bits of data, generates another 8-bit ECC check code, store the another 32 bits of data in the third data die and the fourth data die by using the type 1 interface of the second checking module, and store the another 8-bit ECC check code in the ECC die by using the type 2 interface of the second checking module.

11. The method according to claim 9, wherein n=5, the data dies are two DDR dies that each have a data bit width of 16 bits, and the ECC die is one DDR die that has a data bit width of 16 bits; the type 1 interface of the first checking module is connected to a data interface of a first data die among the data dies by using the DDR PHY, and the type 1 interface of the second checking module is connected to a data interface of a second data die among the data dies by using the DDR PHY;
the first checking module obtains 16 bits of data from the cache module, performs ECC checking on the 16 bits of data, generates an 8-bit ECC check code, stores the 16 bits of data in the first data die by using the type 1 interface of the first checking module, and stores the 8-bit ECC check code in the ECC die by using the type 2 interface of the first checking module; and
the second checking module obtains another 16 bits of data from the cache module, performs ECC checking on the another 16 bits of data, generates another 8-bit ECC check code, stores the 16 bits of data in the second data die by using the type 1 interface of the second checking module, and stores the another 8-bit ECC check code in the ECC die by using the type 2 interface of the second checking module.

12. The method according to claim 9, wherein n=5, the data dies are four DDR dies that each have a data bit width of 8 bits, and the ECC die is one DDR die that has a data bit width of 8 bit; the type 1 interface of the first checking module is connected to data interfaces of a first data die and a second data die among the data dies by using the DDR PHY, and the type 1 interface of the second checking module is connected to data interfaces of a third data die and a fourth data die among the data dies by using the DDR PHY;
the first checking module obtains 16 bits of data from the cache module, performs ECC checking on the 16 bits of data, generates a 4-bit ECC check code, stores the 16 bits of data in the first data die and the second data die by using the type 1 interface of the first checking module, and stores the 4-bit ECC check code in the ECC die by using the type 2 interface of the first checking module; and
the second checking module obtains another 16 bits of data from the cache module, performs ECC checking on the another 16 bits of data, generates another 4-bit ECC check code, stores the 16 bits of data in the third data die and the fourth data die by using the type 1 interface of the second checking module, and stores the another 4-bit ECC check code in the ECC die by using the type 2 interface of the second checking module.

13. A data processing method, wherein the method is applied to a data processing apparatus, a memory and a CPU of the data processing apparatus are integrated in a package, the data processing apparatus comprises data dies, an error checking and correcting ECC die, a double data rate synchronous dynamic random access memory DDR controller, and a DDR physical interface PHY, the data dies and the ECC die are DDR dies of a same data bit width, the DDR PHY is connected to data interfaces of the data dies and the ECC die, a data bit width of a DDR interface of the DDR PHY is a sum of data bit widths of the data dies and the ECC die, the DDR controller is connected to the data interfaces of the data dies and the ECC die by using the DDR PHY, and a total data bit width of the data dies is k bits, wherein k=2ⁿ and n is an integer greater than or equal to 4; and the DDR controller comprises a checking module and a cache module, wherein the checking module is connected to the data interfaces of the data dies and the ECC die by using the DDR PHY, and the checking module is further connected to the cache module; and
the checking module obtains k+m bits of cached data from the cache module, performs ECC checking on the k+m bits of cached data, generates a (1+k/8)-bit ECC check code, stores the k bits of cached data in the data dies, and stores the (1+k/8)-bit ECC check code and the m bits of cached data in the ECC die, wherein 0<m<k/8 and m is an integer.

14. The method according to claim 13, wherein n=6, the data dies are four DDR dies that each have a data bit width of 16 bits, and the ECC die is one DDR die that has a data bit width of 16 bits; and
the checking module obtains 64+m bits of cached data from the cache module, performs ECC checking on the 64+m bits of cached data, generates a 9-bit ECC check code, stores the 64 bits of cached data in the data dies, and stores the 9-bit ECC check code and the m bits of cached data in the ECC die, wherein 0<m<8 and m is an integer.

15. The method according to claim 13, wherein n=5, the data dies are two DDR dies that each have a data bit width of 16 bits, and the ECC die is one DDR die that has a data bit width of 16 bits; and
the checking module obtains 32+m bits of cached data from the cache module, performs ECC checking on the 32+m bits of cached data, generates a 9-bit ECC check code, stores the 32 bits of cached data in the data dies, and stores the 9-bit ECC check code and the m bits of cached data in the ECC die, wherein 0<m<8 and m is an integer.

16. The method according to any one of claims 13 to 15, wherein the m bits of cached data are TAG information and/or directory information cached by the CPU.
